# EUROPÄISCHE PATENTANMELDUNG

(11) **EP 1 840 936 A1**
(43) Veröffentlichungstag der Anmeldung: **03.10.2007**
(21) Anmeldenummer: 06006474.8
(22) Anmeldetag: 29.03.2006
(51) Int. Cl.: H01J 37/32, H01J 37/34

(54) **Sputterkammer zum Beschichten eines Substrats**

(71) Anmelder: Applied Materials GmbH & Co. KG, 63755 Alzenau (DE)
(72) Erfinder: Trassl, Roland, 35392 Gießen (DE); Geisler, Michael, 63607 Wächtersbach (DE); Kastner, Albert, 63457 Hanau (DE)
(74) Vertreter: Schickedanz, Willi

(57) **Zusammenfassung**

Die Erfindung betrifft eine Sputterkammer (1) zum Beschichten von Substraten, bei welcher der so genannte "Picture-Frame-Effekt" beseitigt oder doch stark reduziert ist. Die Dicke der Beschichtung am Rand eines Substrats (8) weicht hierdurch nicht mehr wesentlich von der Dicke der Beschichtung in der Mitte des Substrats ab. Erreicht wird dies dadurch, dass die negative Wirkung des Prozessgases - oder mehrerer Prozessgase -, das in die Sputterkammer eingebracht wird, durch ein zusätzliches Edel- oder Reaktivgas kompensiert wird. An den Rändern der zu beschichtenden Substrate und auf der der Kathode (19) abgewandten Substratseite wird also ein zusätzlicher Gasstrom erzeugt, der dem Prozessgasstrom entgegengerichtet ist.

## Beschreibung

Die Erfindung betrifft eine Sputterkammer zum Beschichten eines Substrats nach dem Oberbegriff des Patentanspruchs 1.

Bei Beschichtungsanlagen für das Beschichten von großflächigen Substraten wird meist das Substrat an einer Beschichtungsquelle vorbeibewegt, die sich in einer Beschichtungskammer befindet. Während der Bewegung des Substrats wird es kontinuierlich beschichtet.

Dabei können sich in der Beschichtungsanlage mehrere solcher hintereinander angeordneter Beschichtungskammern befinden. Weist die Anlage sowohl eine Einschleuse als auch eine Ausschleuse auf, so handelt es sich um eine so genannte Inline-Anlage, und zwar unabhängig von der Zahl der Beschichtungskammern. In der Regel sind bei Inline-Anlagen jedoch eine oder mehrere Beschichtungskammern sowie gegebenenfalls Pumpkammern und Schleusenkammern hintereinander angeordnet, wobei die Beschichtungskammern über Transport- bzw. Verbindungskanäle für Gas mit den in der Nachbarschaft stehenden Kammern verbunden sind.

Der in den Transportkanälen auftretende Strömungsleitwert ist meist klein verglichen mit dem Strömungsleitwert einer Beschichtungskammer in Querrichtung.

In einer solchen Beschichtungskammer werden die lokalen Partialdrücke durch verschiedene Faktoren beeinflusst. Zum einen ändert sich die Gasverteilung durch das sich bewegende Substrat, zum anderen entfaltet eine auf der Substratoberfläche stattfindende Beschichtung eine Saugleistung selektiv für das Reaktivgas, aber eine vernachlässigbare Saugleistung für das Inertgas. Dies wirkt auf die Targetoberfläche zurück, sodass sich die lokalen Prozessbedingungen in Abhängigkeit von der Position des Substrates ändern. Zum anderen sind Verluste, die das Plasma in der Nähe einer ununterbrochenen Wand oder einer plasmanahen Substratoberfläche erleidet, größer als an einer Substratkante. Die unterschiedlichen Partialdrücke der Gase und die unterschiedlichen Plasmawechselwirkungen bewirken eine unterschiedlich hohe Beschichtungsrate, die zu einer schwankenden Schichtdicke des zu beschichtenden Substrates führt.

Bei der dynamischen Beschichtung wird also der lokale Gasdruck durch das sich bewegende Substrat beeinflusst, da es die effektive Pumpleistung ändert und es zu unterschiedlichen Gasströmungen im Randbereich des Substrats kommt. Das führt zu dem so genannten "Picture-Frame-Effekt", der sich durch eine starke Abweichung der Schichtdicke am Rand des Substrates relativ zu der Schichtdicke in der Substratmitte äußert.

Bekannt ist ein Verfahren zur Kontrolle der Abdampfrate bzw. der Zusammensetzung des abzudampfenden Materials während eines Beschichtungsprozesses im Vakuum, wobei potentiometrische Messelektroden in die Beschichtungsanlage eingebaut sind (DE 196 09 970 A1). Mit diesen Messelektroden wird der Anteil eines Gases in der Vakuumkammer oder in einer mit der Vakuumkammer verbundenen Zuleitung mit einem Referenzgas verglichen und die gemessene Potentialdifferenz an eine Regeleinheit weitergeleitet. Mit dieser Regeleinheit wird ein für die Stromversorgung der Kathode verantwortlicher Generator angesteuert. Über diese Anordnung ist es möglich, einen stabilen Sputterprozess zu erhalten.

Ein Verfahren für das Beschichten von Substraten in Inline-Anlagen, bei dem aufgrund der erfassten Position des Substrats die Beschichtungsparameter eingestellt werden, ist ebenfalls bekannt (DE 10 2004 020 466 A1). Dieses Verfahren zeichnet sich dadurch aus, dass ein Modell auf Grundlage der Monte-Carlo-Methode erstellt wird, wodurch eine mittlere dynamische Beschichtungsrate ermittelt wird. Durch Variation der Beschichtungsparameter wie Gasfluss oder Entladungsleistung wird diese mittlere dynamische Beschichtungsrate in der Anlage konstant gehalten.

Weiterhin ist eine Beschichtungsanlage bekannt, bei der eine ausreichend hohe Konzentration von Reaktivgas eine vollständige Reaktion der sich zu bildenden Schicht ermöglicht (DE 102 16 671 A1). Dies wird dadurch ermöglicht, dass in den Substratraum Reaktivgas eingelassen wird.

Aufgabe der Erfindung ist es, eine Vorrichtung für das Beschichten von Substraten bereitzustellen, mit der eine gleichmäßige Beschichtung ermöglicht wird.

Diese Aufgabe wird gemäß den Merkmalen des Patentanspruchs 1 gelöst.

Die Erfindung betrifft somit eine Sputterkammer zum Beschichten von Substraten, bei welcher der so genannte "Picture-Frame-Effekt" beseitigt oder doch stark reduziert ist. Die Dicke der Beschichtung am Rand eines Substrats weicht hierdurch nicht mehr wesentlich von der Dicke der Beschichtung in der Mitte des Substrats ab. Erreicht wird dies dadurch, dass die negative Wirkung des Prozessgases - oder mehrerer Prozessgase -, das in die Sputterkammer eingebracht wird, durch ein zusätzliches Edel- oder Reaktivgas kompensiert wird. An den Rändern der zu beschichtenden Substrate und auf der der Kathode abgewandten Substratseite wird also ein zusätzlicher Gasstrom erzeugt, der dem Prozessgasstrom entgegengerichtet ist.

Der mit der Erfindung erzielte Vorteil besteht insbesondere darin, dass die Kathoden nicht weit im reaktiven Bereich der Kennlinie gefahren werden müssen, d. h. es ergibt sich eine höhere Sputterrate bei geringerer Leistung.

Gemäß der Erfindung ist unterhalb des Substrats, mittig oder auch in den Randbereichen des Substrats, mindestens eine Gaszuführung angeordnet. Durch diese mindestens eine Gaszuführung wird ein Gasstrom erzeugt, der dem von dem Kathodenraum kommenden Gasstrom entgegenwirkt, sodass es in den Randbereichen des Substrats zur Kompensation beider Gasströme kommt. Dadurch wird eine gleichmäßige Beschichtung des Substrats erreicht.

Ein Ausführungsbeispiel der Erfindung ist in den Zeichnungen dargestellt und wird nachfolgend näher erläutert. Es zeigen:
Fig. 1 einen Querschnitt durch eine Sputterkammer;
Fig. 2 einen Schnitt der in Fig. 1 dargestellten Sputterkammer entlang A-A im unteren Abschnitt der Anlage;
Fig. 3 einen Schnitt entlang B-B durch einen Teilbereich der Sputterkammer gemäß Fig. 1 bzw. eine Draufsicht auf Fig. 2;
Fig. 4 einen Schnitt durch eine Variante des unteren Bereichs der Sputterkammer;
Fig. 5 einen Schnitt B-B durch einen Teilbereich der Sputterkammer bei einer Variante des unteren Bereichs bzw. eine Draufsicht auf Fig. 4;
Fig. 6 einen Querschnitt durch eine Sputterkammer mit einem Doppelmagnetron.

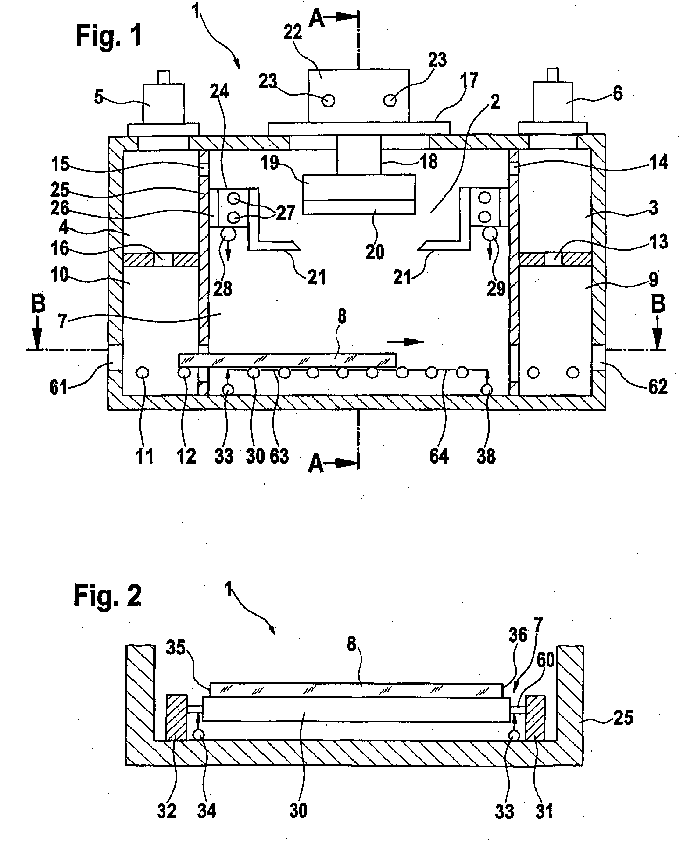

Fig. 1 zeigt einen Schnitt durch eine Sputterkammer 1 mit einem Kathodenraum 2 und zwei benachbarten Pumpräumen 3, 4, die mit jeweils einer Pumpe 5, 6, vorzugsweise einer Turbopumpe ausgestattet sind. Unterhalb dieser Pumpräume 3, 4 sind Nebenpumpkammern 9, 10 angeordnet, zwischen denen ein Substratraum 7 liegt.

In dem Substratraum 7 wird ein Substrat 8 auf Rollen 11, 12, 30 von links nach rechts transportiert, wobei es sich bei dem Substrat 8 um eine Glasplatte handeln kann. Die Pumpräume 3,4 sind über Durchbrüche 13 bis 16 mit dem Substratraum 7, dem Kathodenraum 2 bzw. den Nebenpumpkammern 9, 10 verbunden.

An einem auf der Sputterkammer 1 aufliegenden Deckel 17 ist über eine Halterung 18 eine Kathode 19 angebracht, an der ein Target 20 befestigt ist. Gegenüber der Kathode 19 ist eine Anode 21 in Form einer Blende vorgesehen. Auf dem Deckel 17 befindet sich eine Kathodenabdeckhaube 22, die ein Kühlsystem 23 enthält, in dem vorzugsweise Wasser als Kühlmittel fließt.

Die Anode 21 ist über eine Halterung 24 mit der Wand 25 der Sputterkammer 1 verbunden, wobei zwischen der Halterung 24 und der Wand 25 eine Isolierung 26 vorgesehen ist.

In der Halterung 24 befindet sich ein Kühlsystem 27, in dem ebenfalls Wasser als Kühlmittel fließt.

Unterhalb der Halterung 24 sind Gaszuführungen 28, 29 vorgesehen, über die ein Prozessgas, ein Edelgas, eingelassen werden kann. Es ist jedoch auch möglich, über eine der Gaszuführungen 28, 29 ein Prozessgas und über die andere ein Reaktivgas, z. B. Sauerstoff in den Kathodenraum 2 einströmen zu lassen. Anstatt die Gase getrennt voneinander in den Kathodenraum 2 einzulassen, besteht zudem die Möglichkeit, die für den Sputterprozess gewünschten Gase vorher zu mischen und diese Gasmischung über diese Gaszuführungen 28, 29 in den Kathodenraum 2 zu bringen. Die Gaszuführungen 28, 29 können auch oberhalb der Halterung 24 angeordnet sein. Der Prozessgasstrom bewegt sich dann durch die Öffnung der Blende 21 hindurch in Richtung Substratraum 7. Gegenüber den Gaszuführungen 28, 29 und unterhalb der Ebene des Substrats 8 befinden sich zwei weitere Gaszuführungen 33, 38. Deren Gasströmung ist nach oben gerichtet. Zwischen den Gaszuführungen 33 und 38 können noch weitere Gaszuführungen vorgesehen sein. Beispielsweise kann sich in der Mitte zwischen den Gaszuführungen 33, 38 eine weitere Gaszuführung befinden.

Wie in Fig. 1 zu erkennen, besteht die Sputterkammer 1 aus mehreren Abteilungen, nämlich dem Kathodenraum 2, dem Substratraum 7, den Pumpräumen 3, 4 und den Nebenpumpkammern 9, 10. Die vollständige Glasbeschichtungsanlage besteht aus mehreren, hintereinander geschalteten Sputterkammern 1, nicht dargestellten Transferkammern und Ein- und Ausschleusen, um die Substrate von Atmosphäre in das Prozessvakuum und wieder an Atmosphäre zu bringen.

Bei der Sputterkammer 1 handelt es sich somit um einen strukturierten Rezipienten.

In den verschiedenen Abteilungen 2 bis 4, 7, 9, 10 herrschen unterschiedlich hohe Drücke, wobei in den Pumpräumen 3, 4 der niedrigste und im Kathodenraum 2 der höchste Druck herrscht, da im Kathodenraum 2 über die Gaszuführungen 28, 29 Gas eingelassen wird.

Diese verschiedenen Abteilungen 2 bis 4, 7, 9, 10, in denen unterschiedliche Drücke herrschen, sind durch einen Leitwert getrennt, der meist kleiner ist als das Zehnfache des effektiven Saugvermögens, das durch die Pumpen 5, 6 erreicht werden kann.

Wird nun das Substrat 8 durch Öffnungen 61, 62 von links nach rechts in den Substratraum 7 hineinbewegt, so ändert sich die effektive Pumpleistung der Pumpen 5, 6. Im Randbereich des Substrats 8 kommt es zu unterschiedlichem Verhalten der Gasströmungen. Außerdem wirkt sich die sich im Substratbereich ändernde Plasma-Wand-Wechselwirkung aus. Durch das unterschiedliche Verhalten der Gasströmungen und Plasmabedingungen erhöht oder erniedrigt sich die Beschichtungsrate am Substratrand. Da die unterschiedlichen Gasströmungen insbesondere in den Randbereichen des Substrats 8 auftreten, führt dies dort zu einer ungleichmäßigen Beschichtung.

Diese ungleichmäßige Beschichtung fällt besonders bei sehr kleinen Substraten oder speziell geformten Substraten ins Gewicht, was dazu führen kann, dass das Substrat an den Randbereichen oft eine andere Farbe aufweist als in der Mitte des Substrats.

Derartigen ungleichmäßigen Gasströmungen wird erfindungsgemäß dadurch entgegengewirkt, dass unterhalb des Substrats 8 oder auf der Höhe des Substrats 8 mindestens eine Gaszuführung 33, 38 in der Nähe des Bodens der Sputterkammer 1 vorgesehen ist. Durch diese Gaszuführung 33, 38 kann Prozess- oder Reaktivgas oder eine Mischung dieser beiden Gastypen in dem Substratraum 7 gelangen, um dort die in den Randbereichen auftretenden Gasströmungen zu kompensieren.

Bei den Gaszuführungen 33, 38 handelt es sich um Gasröhrchen mit Öffnungen von etwa 0,8 mm, die im Abstand von ca. 10 cm angeordnet sind. Die Gasröhrchen können quer zur Substratbewegungsrichtung, d. h. parallel zur Kathode 19 sowohl oberhalb als auch unterhalb der Substratebene liegen. Die Gasröhrchen sollen länger sein als die maximale Breite des Substrats 8, d.h. es sind Gasaustrittsöffnungen vorgesehen, die links und rechts außerhalb des Substrats 8 liegen.

Zwischen den Transportrollen 11, 12, 30 sind gekühlte Gegensputterbleche 63, 64 vorgesehen, die das vor oder hinter dem vorbeiführenden Substrat abgeschiedene Material aufsammeln und somit ein Beschichten der Kammerwände unterhalb der Rollen 11, 12, 30 verhindern. Das Absaugen des Bereichs unterhalb der Transportebene erfolgt über Spaltschleusen bzw. Transportöffnungen zu den benachbarten Nebenpumpkammern 9, 10. Die Gegensputterbleche 63, 64 können auch nach links und rechts in die Nebenpumpenkammern 9, 10 verlängert werden.

Das aus dem Kathodenraum 2 kommende Gas strömt dem Gas, welches aus den unterhalb des Substrats 8 angeordneten Gaszuführungen 33, 38 kommt, sowie dem auf den Substratkantenbereich hin diffundierenden Plasma, entgegen.

Vorzugsweise gelangt das aus den Gaszuführungen unterhalb des Substrats 8 kommende Gas mit derselben Massenflussrate zu den Randbereichen des Substrats 8 wie das von dem Kathodenraum 2 kommende Gas. Das von unterhalb des Substrats 8 kommende Gas wird so eingestellt, dass es hinsichtlich seiner Wirkung auf die Schichtbildung, insbesondere auf die Abscheiderate, so wirkt wie die als Wand auf das Plasma wirkende Substratoberfläche. Durch die Gaszuführung unterhalb des Substrats 8 können Verwirbelungen an den Kanten des Substrats kompensiert werden, wie Versuche gezeigt haben. Es ist allerdings nicht restlos geklärt, wie diese Kompensation im Einzelnen funktioniert. Gasströmungen im Vakuum unterliegen nicht der Aerodynamik unter Atmosphäre. Die Gasteilchen strömen im Vakuum so lange geradeaus, bis sie irgendwo anstoßen, z. B. an andere Gasteilchen oder an eine Wand.

Bei einem Druck von 1 x 10⁻³ mbar haben die Teilchen eine mittlere freie Weglänge bei etwa 7 bis 8 cm. Diese Länge hängt aber auch vom Atomradius der Gasteilchen ab, sodass sie für verschiedene Gase unterschiedlich ist.

Ein Teilchen kann bis zur Anode 21 oder zur Kammerwand 25 gelangen. Wegen der Wechselwirkung mit der Oberfläche der Anode 21 oder Kammerwand 25 bleibt das Teilchen oft eine gewisse Zeit haften - so genannter sticking effect -, bevor es die Oberfläche wieder verlässt. Es kann sich nun in irgendeiner Richtung mit irgendeiner Geschwindigkeit bewegen.

Wegen der mittleren freien Weglänge erfolgt unter den Gasteilchen kein Informationsaustausch über Geschwindigkeit und Richtungen, wie dies bei Gasströmungen unter Atmosphärendruck der Fall ist. So werden lokale Schwankungen im Gasdruck nicht dadurch ausgeglichen, dass die Teilchen kollektiv dem Druckgefälle folgen. Vielmehr erfolgt der Druckausgleich über Variationen in der mittleren freien Weglänge und der Anzahl von Stößen, sodass sich die Einwirkung der Pumpe letztlich doch bemerkbar macht.

Die unterhalb des Substrats 8 liegenden Gaszuführungen 33, 38 sind individuell oder als Ganzes einstellbar und steuerbar. Der Gasfluss der Gaszuführungen und seine räumlichseitliche Verteilung können von verschiedenen Parametern abhängig gemacht werden, beispielsweise vom Target-Substrat-Abstand, von der elektrischen Leistung der Sputterkathode, von der Form der Volumina unterhalb der Substratebene, von der chemischen Zusammensetzung des Sputtertargets, von der chemischen Natur der verwendeten Sputtergase, von den Partialdrücken dieser Gase oder von der Substratdicke.

Fig. 2 zeigt einen Schnitt der in Fig. 1 dargestellten Sputterkammer 1 entlang A-A, wobei nur ein Ausschnitt des Substratraums 7 zu sehen ist.

Zu erkennen ist das auf einer Rolle 30 angeordnete Substrat 8, wobei die Rolle 30 über eine Achse 60 mit Trägern 31, 32 verbunden ist. Diese Träger 31,32 können wiederum mit einem Antriebssystem in Verbindung stehen oder ein Teil eines Antriebssystems sein, mit dem die Rolle in Bewegung gesetzt wird. Ein solches Antriebssystem ist in Fig. 2 nicht dargestellt.

Zu erkennen sind jedoch die beiden vorzugsweise einander gegenüber liegenden Gaszuführungen 33, 34. Aus diesen Gaszuführungen 33, 34 gelangt ein Prozess- oder Reaktivgas oder eine Mischung der beiden Gastypen in den Substratraum 7. Dieses Gas strömt dem aus dem Kathodenraum 2 kommenden Gas entgegen.

Die Gaszuführungen 33, 34 sind unterhalb des Substrats 8 angeordnet und reichen über den Randbereich 35, 36 des Substrats 8 hinaus, damit es dort zur Kompensation der beiden Gasströmungen kommt. Um in den Randbereichen 35, 36 des Substrats 8 zu einer Kompensation zu gelangen, sind die Geschwindigkeiten der einander entgegenströmenden Gase in diesen Randbereichen 35, 36 etwa gleich groß.

Dies kann dadurch erreicht werden, dass der Druck des Gases bzw. der dargestellten Gasmischung genau eingestellt wird, bevor es die Gaszuführungen 33, 34 verlässt.

Die Gaszuführungen 33, 34 haben hierbei vorzugsweise einen definierten Abstand zu den Randbereichen 35, 36 des Substrats 8.

Bei der Darstellung der Fig. 2 bewegt sich das Substrat 8 in die Zeichenebene hinein. Handelt es sich bei dem Substrat 8 um Glas, so bewegt es sich mit einer Geschwindigkeit von wenigen Metern pro Minute. Die Strömungsgeschwindigkeit der Gasteilchen ist dem gegenüber um Größenordnungen höher, sodass das sich bewegende Substrat 8 keine Verwirbelungen erzeugt, die mit Verwirbelungen in der Atmosphäre vergleichbar sind. Aber durch die Substratbewegung verändern sich die Strömungsleitwerte in der Vakuumkammer langsam, die auch die lokale Verteilung des Reaktivgasanteils beeinflussen.

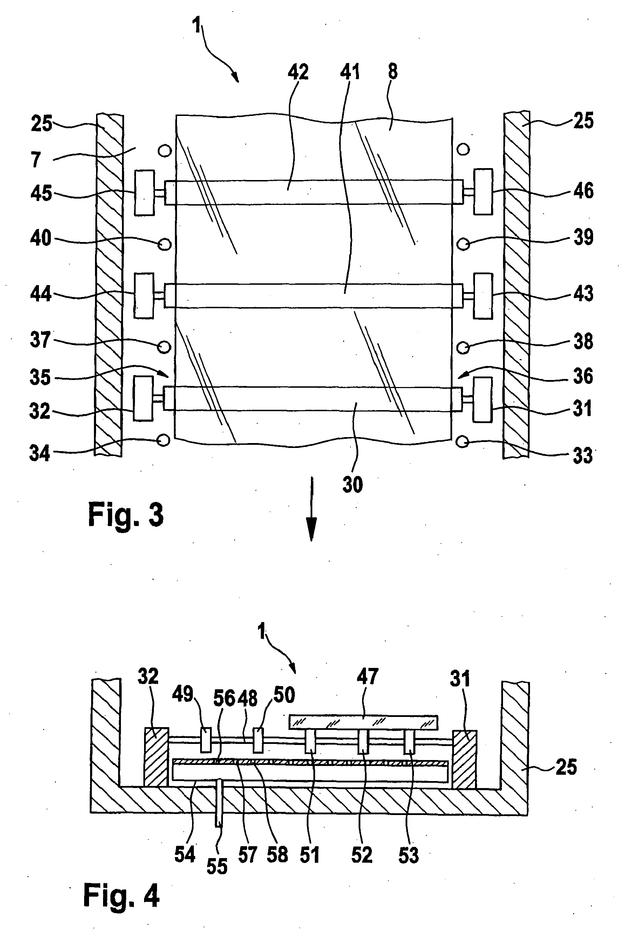

In Fig. 3 ist ein Schnitt entlang B-B durch die Sputterkammer 1 gemäß Fig. 1 gezeigt. Fig. 3 ist somit eine Draufsicht auf die Fig. 2. Das Substrat 8 liegt in dem Substratraum 7 auf Rollen 30, 41, 42, die wiederum mit Trägern 31, 32, 43 bis 46 verbunden sind. Zwischen diesen Trägern 31, 32, 43 bis 46 sind im Randbereich 35, 36 des Substrats 8 mehrere Gaszuführungen 33, 34, 37 bis 40 angeordnet, aus denen in Richtung der Randbereiche 35, 36 Gas strömt, um die von oben kommenden Gasströmungen zu kompensieren.

Damit können über diese individuell einstellbaren Gaszuführungen 33, 34, 37 bis 40 nicht nur ein Gas, sondern auch mehrere Gase gleichzeitig in den Substratraum 7 gelassen werden, z. B. ein Edelgas und ein Reaktivgas oder gar ein Edelgas und mehrere unterschiedliche Reaktivgase. Dabei können die Gase die Gaszuführungen 33, 34, 37 bis 40 schon als entsprechende Gasmischungen mit der gewünschten Zusammensetzung verlassen.

Die die zusätzlichen Gaszuführungen 33, 34, 37 bis 40 verlassenden Gase müssen dabei eine Gasverteilung bewirken, die so geartet ist, dass es im Bereich der Randbereiche 35, 36 des Substrats 8 nicht zu lokalen Schwankungen der Partialdrücke kommt, die den Prozess stören. Dies kann durch Einstellung des Gasflusses geschehen, wobei das Gas bzw. die Gase zuvor in einem den Gaszuführungsrohren vorgeschalteten und hier nicht dargestellten Verteilerrohr gemischt werden.

Die Fig. 4 zeigt einen Schnitt A-A durch eine Variante des unteren Bereichs der Sputterkammer 1. Der Unterschied zu dem in der Fig. 2 gezeigten unteren Bereich besteht darin, dass das Substrat 47 statt auf einer Transportrolle 30 auf mehreren mit einer Welle 48 verbundenen Transportscheiben 49 bis 53 ruht. Außerdem ist statt zwei Einzelgaszuführungen eine Gaslanze 54 vorgesehen, die ihrerseits durch eine Gaszuführung 55 versorgt wird. Die Gaslanze 54 weist mehrere Düsen 56 bis 58 auf, die z. B. in einem Abstand von 10 cm vorgesehen sein können. Diese Düsen sind bis über den Rand des Substrats 47 hinaus vorgesehen.

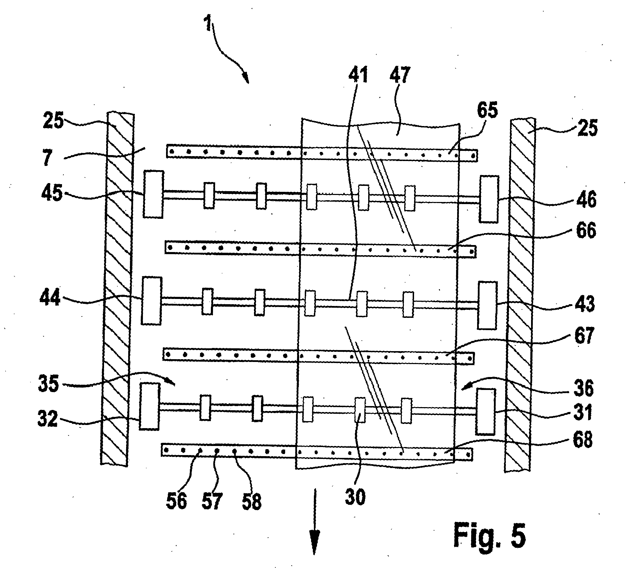

In der Fig. 5 ist ein Schnitt B-B bei einer Variante des unteren Bereichs der Beschichtungskammer dargestellt. Fig. 5 ist somit eine Draufsicht auf die Fig. 4.

Das Substrat 47 nimmt hierbei nur einen Teil der Breite der Beschichtungskammer ein. Man erkennt hierbei, dass mehrere Gaslanzen 65 bis 68 hintereinander angeordnet sind. Statt der vier dargestellten Gaslanzen 65 bis 68 können auch mehr oder weniger als vier Gaslanzen vorgesehen sein. Die Gaslanzen 65 bis 68 weisen linear angeordnete Düsen auf, von denen nur drei mit Bezugszahlen 56, 57, 58 versehen sind.

Mit den verschiedenen Varianten der Gaszuführung ist es möglich, die Beschichtungsverhältnisse bei verschiedenen Typen von Glasbeschichtungsanlagen auf die kleinste Ungleichmäßigkeit der Schichtdicke anzupassen. Dies ist auch dann möglich, wenn die Geometrie der Anlage eine andere ist als die in der Fig. 1 dargestellte.

Weiterhin kann die Schichtdickengleichmäßigkeit auf beliebig geformte zu beschichtende Substrate angepasst werden. Da der "Picture-Frame-Effekt" an allen Rändern einer Scheibe auftritt, spielen die Form der Glasscheibe und deren Abmessungen insofern eine Rolle, als es hierfür nicht mehr ausreicht, die zusätzlichen Gaszuführungen nur im Randbereich der Beschichtungskammer vorzusehen, sondern die Gase nun gemäß der Fig. 5 mittels mehrerer Gaslanzen 65 bis 68 zuzuführen sind, die über die annähernd ganze Kammerbreite Gasaustrittsöffnungen in regelmäßigen Abständen aufweisen. In Glasbeschichtungsanlagen werden nicht nur rechteckige und große Glasscheiben beschichtet, wie in den Fig. 1 bis 3 gezeigt, sondern auch Scheiben mit deutlich kleineren Abmessungen, wie in den Fig. 4 und 5 gezeigt. Auch werden Scheiben mit speziellem und unregelmäßigem Formzuschnitt beschichtet, die darüber hinaus auch noch beliebig und unregelmäßig auf Transportrollen aufliegen.

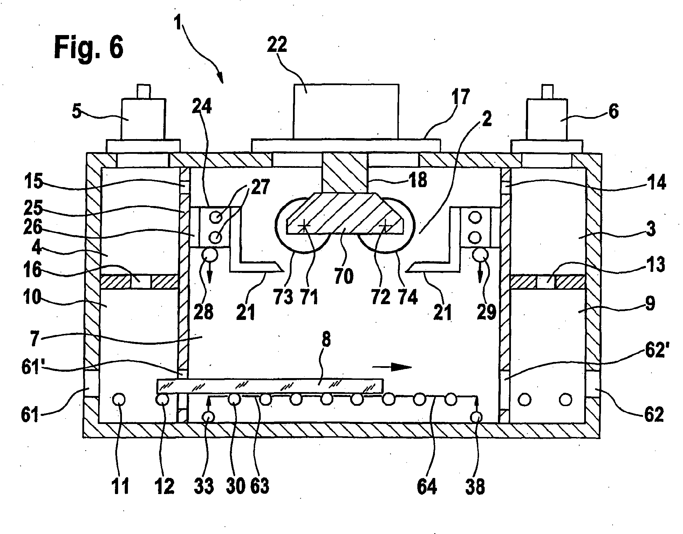

In der Fig. 6 ist eine Sputterkammer 1 gezeigt, die zwei drehbare Magnetrons 73, 74 aufweist, die um ihre Längsachse 71, 72 in einem Lagerblock 70 drehbar sind. In diesem Fall wird die Anode 21 nicht als Anode geschaltet, sondern wirkt nur als Blende, die geerdet ist oder auf floatendem Potential liegt.

## Patentansprüche

1. Sputterkammer (1) zum Beschichten eines Substrats mit einer ersten Gaszuführung (28, 29), **dadurch gekennzeichnet, dass** etwa auf der Höhe des Substrats (8) mindestens eine weitere Gaszuführung (33, 34, 37 - 40) vorgesehen ist.

2. Sputterkammer nach Anspruch 1, **dadurch gekennzeichnet, dass** die Gaszuführung (28, 29) oberhalb des Substrats (8) und die Gaszuführung (33, 34, 37 - 40) auf der Höhe des Substrats (8) einander gegenüberliegende Gasaustrittsöffnungen aufweisen.

3. Sputterkammer nach Anspruch 1, **dadurch gekennzeichnet, dass** die Gaszuführung (33, 34, 37 - 40) auf der Höhe des Substrats (8) unterhalb des Substrats (8) angeordnet ist.

4. Sputterkammer nach Anspruch 1, **dadurch gekennzeichnet, dass** die Gaszuführung (33, 34, 37 - 40) auf der Höhe des Substrats (8) in einem Randbereich (35, 36) dieses Substrats (8) angeordnet ist.

5. Sputterkammer nach Anspruch 4, **dadurch gekennzeichnet, dass** die Gaszuführung (33, 34, 37 - 40) einen seitlichen Abstand zum Randbereich (35, 36) besitzt.

6. Sputterkammer nach Anspruch 1, **dadurch gekennzeichnet, dass** die Gaszuführung (28, 29) oberhalb des Substrats (8) unterhalb einer Kathode (19) der Sputterkammer (1) angeordnet ist.

7. Sputterkammer nach Anspruch 1, **dadurch gekennzeichnet, dass** sie einen Kathodenraum (2), einen Substratraum (7), wenigstens einen Pumpraum (3, 4) und wenigstens einen Vorvakuumraum (9, 10) aufweist.

8. Sputterkammer nach Anspruch 7, **dadurch gekennzeichnet, dass** sich der Kathodenraum (2) zwischen einer Kathode (19) und einer Anode (21) befindet.

9. Sputterkammer nach Anspruch 7, **dadurch gekennzeichnet, dass** der Substratraum (7) zwischen Anode (21) und Substrat (8) vorgesehen ist.

10. Sputterkammer nach Anspruch 7, **dadurch gekennzeichnet, dass** zu beiden Seiten des Kathodenraums (2) jeweils ein Pumpraum (3, 4) vorgesehen ist.

11. Sputterkammer nach Anspruch 7, **dadurch gekennzeichnet, dass** zu beiden Seiten des Substratraums (7) jeweils ein Vorvakuumraum (9, 10) vorgesehen ist.

12. Sputterkammer nach Anspruch 7, **dadurch gekennzeichnet, dass** der Pumpraum (3, 4) gasmäßig mit dem Kathodenraum (2) und dem Vorvakuumraum (9, 10) verbunden ist.

13. Sputterkammer nach Anspruch 8, **dadurch gekennzeichnet, dass** die Anode (21) als Blende ausgebildet ist, durch die gesputtertes Targetmaterial auf das Substrat (8) gelangt.

14. Sputterkammer nach Anspruch 1 und Anspruch 8, **dadurch gekennzeichnet, dass** die Gaszuführung (28, 29) oberhalb des Substrats (8) im Substratraum (7) und hinter der Blende (21) angeordnet ist.

15. Sputterkammer nach Anspruch 1, **dadurch gekennzeichnet, dass** die weitere Gaszuführung eine Gaslanze (54) mit mehreren Düsen (56 - 58) ist.

16. Sputterkammer nach Anspruch 1, **dadurch gekennzeichnet, dass** die erste Gaszuführung (28, 29) oberhalb des Substrats (8) angeordnet ist.

17. Sputterkammer nach Anspruch 1, **dadurch gekennzeichnet, dass** die erste Gaszuführung unterhalb des Substrats (8) angeordnet ist.

## Geänderte Patentansprüche

### Geänderte Patentansprüche gemäss Regel 86(2) EPÜ.

**1.** Sputterkammer (1) zum Beschichten eines Substrats (8), mit einer ersten Gaszuführung (28, 29) oberhalb des Substrats (8), die eine Gasströmung in Richtung auf das Substrat (8) abgibt, und mit einer weiteren Gaszuführung (33, 34, 37 - 40), die etwa auf der Höhe des Substrats (8) vorgesehen ist, **dadurch gekennzeichnet, dass** die Gasströmungen der Gaszuführungen (28, 29; 33, 34, 37 - 40) einander entgegengerichtet sind und sich an den Rändern des zu beschichtenden Substrats (8) überlagern.

**2.** Sputterkammer nach Anspruch 1, **dadurch gekennzeichnet, dass** die Gaszuführung (28, 29) oberhalb des Substrats (8) und die Gaszuführung (33, 34, 37 - 40) auf der Höhe des Substrats (8) einander gegenüberliegende Gasaustrittsöffnungen aufweisen.

**3.** Sputterkammer nach Anspruch 1, **dadurch gekennzeichnet, dass** die Gaszuführung (33, 34, 37 - 40) auf der Höhe des Substrats (8) unterhalb des Substrats (8) angeordnet ist.

**4.** Sputterkammer nach Anspruch 1, **dadurch gekennzeichnet, dass** die Gaszuführung (33, 34, 37 - 40) auf der Höhe des Substrats (8) in einem Randbereich (35, 36) dieses Substrats (8) angeordnet ist.

**5.** Sputterkammer nach Anspruch 4, **dadurch gekennzeichnet, dass** die Gaszuführung (33, 34, 37 - 40) einen seitlichen Abstand zum Randbereich (35, 36) besitzt.

**6.** Sputterkammer nach Anspruch 1, **dadurch gekennzeichnet, dass** die Gaszuführung (28, 29) oberhalb des Substrats (8) unterhalb einer Kathode (19) der Sputterkammer (1) angeordnet ist.

**7.** Sputterkammer nach Anspruch 1, **dadurch gekennzeichnet, dass** sie einen Kathodenraum (2), einen Substratraum (7), wenigstens einen Pumpraum (3, 4) und wenigstens einen Vorvakuumraum (9, 10) aufweist.

**8.** Sputterkammer nach Anspruch 7, **dadurch gekennzeichnet, dass** sich der Kathodenraum (2) zwischen einer Kathode (19) und einer Anode (21) befindet.

**9.** Sputterkammer nach Anspruch 7, **dadurch gekennzeichnet, dass** der Substratraum (7) zwischen Anode (21) und Substrat (8) vorgesehen ist.

**10.** Sputterkammer nach Anspruch 7, **dadurch gekennzeichnet, dass** zu beiden Seiten des Kathodenraums (2) jeweils ein Pumpraum (3, 4) vorgesehen ist.

**11.** Sputterkammer nach Anspruch 7, **dadurch gekennzeichnet, dass** zu beiden Seiten des Substratraums (7) jeweils ein Vorvakuumraum (9, 10) vorgesehen ist.

**12.** Sputterkammer nach Anspruch 7, **dadurch gekennzeichnet, dass** der Pumpraum (3, 4) gasmäßig mit dem Kathodenraum (2) und dem Vorvakuumraum (9, 10) verbunden ist.

**13.** Sputterkammer nach Anspruch 8, **dadurch gekennzeichnet, dass** die Anode (21) als Blende ausgebildet ist, durch die gesputtertes Targetmaterial auf das Substrat (8) gelangt.

**14.** Sputterkammer nach Anspruch 1 und Anspruch 8, **dadurch gekennzeichnet, dass** die Gaszuführung (28, 29) oberhalb des Substrats (8) im Substratraum (7) und hinter der Blende (21) angeordnet ist.

**15.** Sputterkammer nach Anspruch 1, **dadurch gekennzeichnet, dass** die weitere Gaszuführung eine Gaslanze (54) mit mehreren Düsen (56 - 58) ist.

**16.** Sputterkammer nach Anspruch 1, **dadurch gekennzeichnet, dass** die erste Gaszuführung (28, 29) oberhalb des Substrats (8) angeordnet ist.

**17.** Sputterkammer nach Anspruch 1, **dadurch gekennzeichnet, dass** die erste Gaszuführung unterhalb des Substrats (8) angeordnet ist.
